# EUROPÄISCHE PATENTSCHRIFT

(11) **EP 3 387 667 B1**
(45) Veröffentlichungstag und Bekanntmachung des Hinweises auf die Patenterteilung: **01.05.2024**
(21) Anmeldenummer: 16805797.4
(22) Anmeldetag: 02.12.2016
(51) Int. Cl.: H01L 21/02, H01L 21/304, H01L 21/66

(54) **MONOKRISTALLINE HALBLEITERSCHEIBE UND VERFAHREN ZUR HERSTELLUNG EINER HALBLEITERSCHEIBE**
MONOCRYSTALLINE SEMICONDUCTOR WAFER AND METHOD FOR PRODUCING A SEMICONDUCTOR WAFER
PLAQUETTE DE SEMI-CONDUCTEUR MONOCRISTALLIN ET PROCÉDÉ DE PRODUCTION D'UNE PLAQUETTE DE SEMI-CONDUCTEUR

(30) Priorität: 11.12.2015 DE 102015224933
(43) Veröffentlichungstag der Anmeldung: 17.10.2018
(73) Patentinhaber: Siltronic AG, 81677 München (DE)
(72) Erfinder: RÖTTGER, Klaus, 83549 Bachmehring (DE); BECKER, Herbert, 84489 Burghausen (DE); MISTUR, Leszek, 84489 Burghausen (DE); MÜHE, Andreas, 35576 Wetzlar (DE)
(74) Vertreter: Killinger, Andreas
(86) Internationale Anmeldenummer: PCT/EP2016/079524
(87) Internationale Veröffentlichungsnummer: WO 2017/097670

(56) Entgegenhaltungen:
- JP-A- 2012 000 714
- US-A1- 2001 018 271
- US-A1- 2010 056 027
- US-A1- 2015 162 181
- E. SOHN ET AL: "New results in hydrodynamic radial polishing using HyDRa", SPIE - INTERNATIONAL SOCIETY FOR OPTICAL ENGINEERING. PROCEEDINGS, Bd. 5869, 18. August 2005 (2005-08-18), Seite 58690C, XP055341195, US ISSN: 0277-786X, DOI: 10.1117/12.637409 ISBN: 978-1-5106-0753-8

## Beschreibung

Gegenstand der Erfindung ist eine monokristalline Halbleiterscheibe mit einer geringen Rauheit Rₐ und einer hervorragenden Ebenheit in einem an den Rand angrenzenden Bereich. Gegenstand der Erfindung ist auch ein mehrstufiges Verfahren, das zur Herstellung derartiger Halbleiterscheiben geeignet ist.

### Stand der Technik

Einkristalline Halbleiterscheiben, z. B. Siliciumscheiben, die für die Herstellung elektronischer Bauelemente verwendet werden, müssen eine äußerst ebene Oberfläche aufweisen. Anderenfalls können die im Nanometer-Bereich liegenden Strukturen bei der Photolithographie nicht scharf auf der Oberfläche abgebildet werden. Aufgrund der immer weiter fortschreitenden Miniaturisierung der elektronischen Bauelemente steigen die Anforderungen bezüglich der Ebenheit ständig. Der unmittelbar an den Rand angrenzende Bereich der Siliciumscheibe lässt sich dabei aufgrund verschiedenster Effekte besonders schwer einebnen. Die Doppelseitenpolitur ist ein geeignetes Verfahren, um in der Massenproduktion extrem ebene Siliciumscheiben mit guten lokalen Geometriewerten im Randbereich zu erreichen. Beispielsweise kann bei einem Randausschluss von 1 mm ein ESFQR_{avg} von etwa 30 nm erreicht werden. Der Parameter ESFQR und dessen Bestimmung sind in der SEMI-Norm M67-1108 definiert. Es handelt sich dabei um einen lokalen, auf radial am Rand der Siliciumscheibe angeordneten Messfeldern bestimmten Ebenheitswert. Der Mittelwert der ESFQR-Werte aller Messfelder einer Siliciumscheibe wird mit ESFQR_{avg} abgekürzt.

Allerdings ist es sehr schwierig, die Ebenheit am Rand mittels der Doppelseitenpolitur noch deutlich zu verbessern, da verschiedene Einflussgrößen wie die Anströmung der Poliersuspension am Rand und die Kompression des Poliertuchs zu nicht vermeidbaren Fehlern führen. Durch geeignete Wahl von Prozessführung und Hilfsstoffen kann zwar das globale Profil der bearbeiteten Halbleiterscheibe relativ frei von konvex bis konkav eingestellt werden. Trotzdem lässt sich selbst bei einer insgesamt konkaven Form ein Abfall der Dicke unmittelbar angrenzend an den Scheibenrand nicht vermeiden. Letzterer hat unmittelbaren Einfluss auf die erreichbaren ESFQR-Werte.

Wegen der mit der Doppelseitenpolitur verbundenen Einschränkungen wurde ein Verfahren entwickelt, mit dem die Ebenheit der Siliciumscheiben gezielt und lokal verbessert werden kann. Es handelt sich dabei um das PACE-Verfahren ("Plasma Assisted Chemical Etching", übersetzt "plasmaunterstütztes Chemisches Ätzen"). Dabei wird ein wenige Millimeter großer Plasmaätzkopf mit definierter Geschwindigkeit über die Scheibenoberfläche geführt, wobei der Materialabtrag an einer bestimmten Position durch die Verweilzeit des Plasmaätzkopfs an der betreffenden Stelle, d.h. durch dessen Geschwindigkeit bestimmt wird.

EP0798766A1 beschreibt die Anwendung von PACE zur Verbesserung der Ebenheit. Dabei wird eine Halbleiterscheibe nach mechanischer Bearbeitung zunächst poliert und danach deren Dickenverteilung gemessen. Basierend auf den Ergebnissen der ortsabhängigen Dickenmessung wird die Scheibe anschließend dem PACE-Verfahren unterworfen, wobei dieses so gesteuert wird, dass an dickeren Stellen mehr Material abgetragen wird als an dünneren, sodass lokale Dickenunterschiede ausgeglichen werden. Danach wird die Scheibe einer Schleierfrei-Politur unterworfen, um die durch den PACE-Schritt hervorgerufene Rauheit und Störungen des Kristallgitters (sog. "Damage") zu beseitigen.

Die Schrift JP 2012 000714 A beschreibt ein Verfahren, bei dem ein Polierkissen verwendet wird, die eine Polierschicht aufweist, deren Oberfläche in Druckkontakt mit einem zu polierenden Material gebracht wird, wobei die Polierschicht aus Polyurethanschaum gebildet ist, der eine Vielzahl von Luftblasen enthält. Die Vielzahl der Luftblasen besteht dabei zu 90 Prozent oder mehr aus Luftblasen.

Die Schrift US 2010/056027 A1 beschreibt ein Verfahren, das das Polieren der Rückseite der Halbleiterscheibe mittels CMP umfasst, wobei ein Materialabtrag mit einem Profil entlang des Durchmessers der Halbleiterscheibe erzeugt wird, demzufolge der Materialabtrag in einem Zentrumsbereich der Rückseite höher ist, als in einem Randbereich der Rückseite; und das Polieren der Vorderseite der Halbleiterscheibe mittels CMP, wobei ein Materialabtrag mit einem Profil entlang des Durchmessers der Halbleiterscheibe erzeugt wird, demzufolge der Materialabtrag in einem Zentrumsbereich der Vorderseite niedriger ist, als in einem Randbereich der Vorderseite.

Da Rauheit und Damage nach PACE vergleichsweise hoch sind, muss bei der nachfolgenden Schleierfrei-Politur viel Material, beispielsweise 3 µm, abgetragen werden, um Rauheit und Damage zu entfernen. Dies ist wiederum mit einer nicht vermeidbaren Verschlechterung der Ebenheit im äußersten Randbereich der Scheibe verbunden, sodass auch mittels PACE keine beliebig gute Ebenheit im Randbereich zu erreichen ist. Außerdem kann die stets als Einseitenpolitur durchgeführte Schleierfreipolitur längerwellige Rauheiten (z.B. mit einer Grenzwellenlänge von 250 µm), grundsätzlich nicht gut einebnen, insbesondere wenn weiche Schleierfreipoliertücher verwendet werden.

Aus der beschriebenen Problematik ergab sich die Aufgabenstellung der Erfindung.

Die Aufgabe der Erfindung wird gelöst durch eine monokristalline Halbleiterscheibe mit einer mittleren Rauheit Rₐ von höchstens 0,8 nm bei einer Grenzwellenlänge von 250 µm, gekennzeichnet durch einen ESFQR_{avg} von 8 nm oder weniger bei einem Randausschluss von 1 mm.

Die Aufgabe wird ebenfalls gelöst durch ein Verfahren zur Herstellung einer monokristallinen Halbleiterscheibe, umfassend folgende Schritte in der angegebenen Reihenfolge:
- Gleichzeitig beidseitige Politur der Halbleiterscheibe,
- lokale Material abtragende Bearbeitung mindestens eines Teils mindestens einer Fläche der Halbleiterscheibe mit einem Flüssigkeitsstrahl, der suspendierte Hartstoffpartikel enthält, und der mit Hilfe einer Düse auf einen kleinen Bereich der Fläche gerichtet wird, wobei die Düse derart über den zu behandelnden Teil der Fläche bewegt wird, dass ein vordefinierter Geometrie-Parameter der Halbleiterscheibe verbessert wird und
- Politur der wenigstens einen Fläche der Halbleiterscheibe.

Das erfindungsgemäße Verfahren nutzt die für die Bearbeitung optischer Gläser bekannte Technik des "Fluid Jet Polishing" (FJP; übersetzt "Politur mittels eines Flüssigkeitsstrahls"), um die Ebenheit monokristalliner Halbleiterscheiben erheblich zu verbessern. Gläser sind im Gegensatz zu monokristallinen Halbleiterscheiben amorphe Festkörper, die kein geordnetes Kristallgitter aufweisen. Störungen einer Kristallgitterstruktur durch die Einwirkung der mit hoher Geschwindigkeit auf die zu bearbeitende Oberfläche treffenden Hartstoffpartikel können bei amorphen Materialien im Gegensatz zu kristallinen Materialien nicht auftreten. Überraschenderweise führt FJP aber auch bei monokristallinen Halbleiterscheiben nicht zu tieferen Kristallgitterschäden. Daher reicht es aus, die mit FJP behandelte Seite der Halbleiterscheibe einer kurzen Schleierfreipolitur mit geringem Materialabtrag zu unterziehen, um eine einheitliche geringe Rauheit und eine damagefreie Oberfläche zu erzielen. Der geringe Abtrag bei der Schleierfreipolitur stellt sicher, dass die mittels FJP erzielte Ebenheit bis zum äußersten Rand durch die Schleierfreipolitur nur unwesentlich verschlechtert wird.

Somit ermöglicht das erfindungsgemäße Verfahren erstmals die Herstellung von Halbleiterscheiben gemäß Anspruch 1, die einerseits eine für polierte Halbleiterscheiben typische geringe Rauheit, andererseits aber gleichzeitig eine durch Polieren nicht erreichbare Ebenheit bis zum äußersten Rand aufweisen. Auch die Nutzung von PACE führt nicht zu dieser Kombination von Eigenschaften.

Das erfindungsgemäße Verfahren führt unmittelbar zu einer Halbleiterscheibe gemäß Anspruch 1. Vorzugsweise hat die Halbleiterscheibe gemäß Anspruch 1 somit eine polierte Oberfläche ohne eine darauf abgeschiedene epitaktische Schicht. Wird nachfolgend eine epitaktische Schicht abgeschieden, kann mittels einer geeigneten Prozessführung die Ebenheit am Rand nochmals (geringfügig) verbessert werden. Die erfindungsgemäße Halbleiterscheibe eignet sich daher auch als Substrat für die Herstellung einer epitaktisch beschichteten Halbleiterscheibe mit hervorragender Ebenheit im Randbereich.

### Kurzbeschreibung der Figuren

**Fig. 1** zeigt ein bevorzugtes, mittels einer gleichzeitig beidseitigen Politur erzeugtes radiales Profil der Vorderseite einer Halbleiterscheibe sowie ein mittels nachfolgender FJP-Bearbeitung daraus erzeugtes Profil.
**Fig. 2** zeigt ein anderes, mittels einer gleichzeitig beidseitigen Politur erzeugtes radiales Profil der Vorderseite einer Halbleiterscheibe sowie ein mittels nachfolgender FJP-Bearbeitung daraus erzeugtes Profil.

### Liste der verwendeten Bezugszeichen

- **1**: radiales Profil einer Halbleiterscheibe nach DSP und vor FJP
- **2**: radiales Profil einer Halbleiterscheibe nach FJP

### Detaillierte Beschreibung der Erfindung und bevorzugter Ausführungsformen

Die erfindungsgemäße Halbleiterscheibe zeichnet sich durch eine Rauheit Rₐ ("mittlere Rauheit") von 0,8 nm oder weniger, vorzugsweise 0,5 nm oder weniger aus, wie sie für polierte Halbleiterscheiben typisch ist. Der angegebene Wert bezieht sich auf die mittlere Rauheit mit einer Grenzwellenlänge von 250 µm, bestimmt durch Weißlichtinterferometrie. Gleichzeitig weist die erfindungsgemäße Halbleiterscheibe aber einen die Ebenheit im Randbereich charakterisierenden Wert ESFQR_{avg} von 8 nm oder weniger, vorzugsweise von 5 nm oder weniger auf. Mittels einer Schleierfreipolitur gemäß dem Stand der Technik lässt sich eine Rauheit Rₐ von bis zu 0,2 nm oder gar 0,1 nm erzielen.

Damit ist eine erfindungsgemäße Halbleiterscheibe erheblich weniger rau als nach einer PACE-Bearbeitung, andererseits ist sie am Rand deutlich ebener als nach einer Doppel- und Einseitenpolitur gemäß dem Stand der Technik.

Vorzugsweise weist eine erfindungsgemäße Halbleiterscheibe einen mittels der Poly-UTP-Methode bestimmten Gehalt von höchstens 3×10¹⁰ cm⁻², vorzugsweise von höchstens 1×10¹⁰ cm⁻² für jedes der beiden Elemente Kupfer und Nickel auf. Die Poly-UTP-Methode wird im nachfolgenden Absatz beschrieben. Derart geringe Metallkonzentrationen können nicht erreicht werden, wenn eine Bearbeitung mittels PACE erfolgt. PACE führt zu einer Kontamination der Halbleiterscheibe mit Metallen wie Kupfer und Nickel, die sich aufgrund der hohen Diffusionsgeschwindigkeit dieser Metalle nicht auf die Scheibenoberfläche beschränkt und daher auch nicht durch eine geeignete Reinigung entfernt werden kann.

Die Poly-UTP-Methode ist ein Verfahren, um sowohl Bulkmetalle als auch Oberflächenmetalle gleichzeitig zu detektieren. Die Wiederfindungsrate ist ausgesprochen hoch. Die Methode ist besonders dazu geeignet, vor allem schnell diffundierende Elemente wie Kupfer und Nickel nachzuweisen. Auf eine zu analysierende Siliciumscheibe wird in einem Quarz-Rohr-Reaktor beidseitig eine ca. 1 µm dicke polykristalline Siliciumschicht als externer Getter abgeschieden. Im Laufe einer weiteren thermischen Behandlung diffundieren Kupfer und Nickel aus dem Bulk nahezu quantitativ an die Grenzfläche zwischen mono- und polykristallinem Silicium. Nach dem Abkühlen wird diese polykristalline Siliciumschicht nasschemisch abgeätzt. Dann wird die Ätzlösung verdampft, die Rückstände in einem Gemisch aus HF/HNO₃ wieder aufgelöst und in ultrareinem Wasser gelöst. Diese Lösung mit den darin gelösten Verunreinigungen wird schließlich mittels ICP-MS ("inductively coupled plasma mass spectrometry") bestimmt. Die Gesamtmenge jedes einzelnen Metalls wird in der Einheit Atome pro Quadratzentimeter (cm⁻²) angegeben.

Die erfindungsgemäße Halbleiterscheibe besteht vorzugsweise im Wesentlichen, d.h. zu 90 % (bezogen auf die Stoffmenge) oder mehr, aus Silicium. Vorzugsweise hat sie eine kreisrunde Form mit einem Durchmesser von wenigstens 300 mm, wobei auch größere Durchmesser von beispielsweise bis zu 450 mm möglich sind.

Eine Möglichkeit, derartige Halbleiterscheiben herzustellen, bietet das nachfolgend näher beschriebene Verfahren:
Vorzugsweise wird zunächst eine Halbleiterscheibe gemäß dem Stand der Technik hergestellt: Dazu wird in der Regel ein Einkristall in Scheiben geschnitten (vorzugsweise mittels einer Mehrfachdrahtsäge, engl. "multi wire saw", MWS). Die Halbleiterscheiben werden dann mechanisch (durch Läppen oder Schleifen oder eine Kombination davon) und chemisch (saures oder alkalisches Ätzen oder eine Kombination davon) bearbeitet.

Erfindungsgemäß werden beide Seiten der so hergestellten Halbleiterscheibe gleichzeitig chemisch-mechanisch poliert. Dieser Verfahrensschritt ist auch als Doppelseitenpolitur (DSP) bekannt und beispielsweise in DE102013201663A1 beschrieben. Vorzugsweise ist die Doppelseitenpolitur mit einem Materialabtrag von insgesamt 1 bis 20 µm, besonders bevorzugt 2 bis 12 µm verbunden. Angegeben ist die Summe des Materialabtrags auf beiden Seiten der Halbleiterscheibe, d.h. die resultierende Dickenabnahme. Nach der Doppelseitenpolitur weist die Oberfläche der Halbleiterscheibe vorzugsweise eine mittlere Rauheit Rₐ von 0,01 bis 0,1 nm bei einer Grenzwellenlänge von 10 µm und von 0,07 bis 0,7 nm bei einer Grenzwellenlänge von 250 µm auf.

Nach erfolgter Doppelseitenpolitur wird die Ebenheit der Halbleiterscheibe erfindungsgemäß mittels des FJP-Verfahrens verbessert. Dazu ist einerseits der zu optimierende Geometrie-Parameter festzulegen, andererseits muss die Geometrie der Halbleiterscheibe nach der Doppelseitenpolitur bekannt sein.

Für die Beschreibung der Geometrie einer Halbleiterscheibe existiert eine große Auswahl von Parametern, die für die gesamte Halbleiterscheibe oder für einzelne Teilflächen (sog. "sites") definiert sind und sich zudem darin unterscheiden, wie die Referenzebene für die Ebenheitsmessung definiert ist und wie sich der Wert des Parameters aus den Abweichungen von dieser Referenzebene berechnet. Welcher Parameter als besonders aussagekräftig herangezogen wird, hängt unter anderem vom nachfolgenden Prozess für die Herstellung elektronischer Bauelemente und dessen einzelnen Schritten ab. Besonders gebräuchliche Geometrie-Parameter sind beispielsweise die Parameter GBIR (ein globaler Ebenheitsparameter mit einer durch die Rückseite der Halbleiterscheibe definierten Referenzebene) und SFQR (ein lokaler, site-bezogener Ebenheitsparameter mit durch die Vorderseite definierter Referenzebene). Ein Spezialfall ist der Parameter ESFQR, der ähnlich wie der Parameter SFQR definiert ist, jedoch mit radialer Anordnung der Messfelder und beschränkt auf den Randbereich der Halbleiterscheibe. Die genannten Parameter sind in SEMI-Normen definiert, der ESFQR in der SEMI-Norm M67-1108. Die zitierte SEMI-Norm schlägt für den ESFQR Messfelder mit einer radialen Länge von 30 mm vor. Die Breite der Messfelder ergibt sich durch eine gleichmäßige Aufteilung in 72 gleich große Sektoren. Alle ESFQR- und ESFQR_{avg}-Werte in dieser Beschreibung beziehen sich auf diese Messfeld-Definition unter Berücksichtigung eines Randausschlusses von 1 mm.

Grundsätzlich kann das FJP-Verfahren zur Optimierung der Geometrie der Halbleiterscheibe bezüglich jedes beliebigen Geometrie-Parameters verwendet werden. Soll beispielsweise eine Halbleiterscheibe gemäß Anspruch 1 hergestellt werden, so ist der Parameter ESFQR zur Optimierung heranzuziehen.

Die zweite Voraussetzung für die Geometrie-Optimierung mittels des FJP-Verfahrens ist, dass die Geometrie der Halbleiterscheibe nach der Doppelseitenpolitur bekannt ist. Dazu bestehen zwei Möglichkeiten, die für das erfindungsgemäße Verfahren genutzt werden können:
a) Nach der gleichzeitig beidseitigen Politur einer jeden Halbleiterscheibe wird deren Geometrie gemessen. Auf Basis dieser individuellen Messung wird bestimmt, an welcher Stelle der Halbleiterscheibe wie viel Material mittels FJP abgetragen werden muss, um den vordefinierten Geometrie-Parameter auf den gewünschten Wert zu verbessern.
b) Falls die Doppelseitenpolitur ein sehr gut reproduzierbares Ergebnis hinsichtlich der Geometrie der polierten Halbleiterscheiben liefert, kann auch auf eine Geometriemessung jeder einzelnen Halbleiterscheibe verzichtet werden. In diesem Fall kann es ausreichen, die ortsabhängigen Materialabträge für das nachfolgende FJP-Verfahren auf der Basis von Daten zu berechnen, die aus Messungen gleichartig hergestellter Halbleiterscheiben gewonnen wurden, beispielsweise durch eine Mittelung über eine bestimmte Anzahl gemessener Stichproben.

Im nächsten Schritt des erfindungsgemäßen Verfahrens wird zumindest eine Fläche der Halbleiterscheibe (in der Regel die Fläche, auf der später elektronische Bauelemente hergestellt werden) mit dem FJP-Verfahren bearbeitet. Das FJP-Verfahren ist als lokales Bearbeitungsverfahren in der Lage, in Abhängigkeit von der Position auf der zu bearbeitenden Fläche der Halbleiterscheibe unterschiedlich viel Material abzutragen und so die Geometrie ausgehend von der bekannten Geometrie nach der Doppelseitenpolitur zu verbessern.

Beim FJP-Verfahren handelt es sich um eine lokale, Material abtragende Bearbeitung mit einem Poliermittelstrahl. Das Poliermittel besteht aus einer Flüssigkeit, in der Hartstoffpartikel suspendiert sind. Der Strahl wird mit Hilfe einer Düse auf einen kleinen Bereich der Fläche gerichtet. Die Düse wird über den zu behandelnden Teil der Fläche bewegt, wobei die Düse selbst oder die Halbleiterscheibe oder beide in geeigneter Kombination bewegt werden können. Beispielsweise kann eine Rotation der Halbleiterscheibe vorteilhaft mit einer linearen Bewegung der Düse kombiniert werden. Die Relativbewegung der Düse bezogen auf die Halbleiterscheibe kann beispielsweise in parallelen, geraden Linien (zeilenweise), spiralförmig oder auf Kreisbahnen parallel zum Rand der Halbleiterscheibe erfolgen. Ein zu bearbeitender Bereich kann jeweils nur einmal oder auch mehrfach oder mit Überlappung überstrichen werden.

Der ortsabhängige Materialabtrag lässt sich vorzugsweise mittels der Aufenthaltsdauer der Düse an einem Ort, d.h. über die Geschwindigkeit, mit der die Düse an dem Ort über die Fläche der Halbleiterscheibe bewegt wird, steuern. Bei geringer Geschwindigkeit der Düse erfolgt ein vergleichsweise hoher Materialabtrag und umgekehrt. Vorzugsweise wird die Bewegung der Düse basierend auf der vorliegenden Geometrie der Halbleiterscheibe nach der Doppelseitenpolitur so gesteuert, dass lokale Erhebungen, die sich auf den zu optimierenden Geometrie-Parameter auswirken, abgetragen werden. Auf diese Weise wird die Geometrie der Halbleiterscheibe hinsichtlich des betreffenden Parameters verbessert.

Vorzugsweise wird für das erfindungsgemäße Verfahren eine beispielsweise in WO02/074489A1 beschriebene Variante des FJP-Verfahrens eingesetzt, bei der die Düse, durch die der Poliermittelstrahl austritt, in einem Abstand von 0,5 bis 3 mm, vorzugsweise 0,7 bis 2 mm über die zu bearbeitende Fläche geführt wird, sodass zwischen der Stirnseite der Düse und der bearbeiteten Fläche ein Ringspalt entsteht. Die Düse hat vorzugsweise einen Durchmesser von 4 bis 8 mm. Die Fläche des Ringspalts ist kleiner als die Querschnittsfläche des Einlasses, durch den das Poliermittel in die Düse strömt. Das Poliermittel staut sich zwischen der Düse und der zu bearbeitenden Fläche und strömt überwiegend parallel zur zu bearbeitenden Fläche durch den Ringspalt im Wesentlichen radial nach außen. Der Materialabtrag wird bei dieser Variante überwiegend durch die radial nach außen strömende Flüssigkeit mit suspendierten Hartstoffpartikeln erzielt, und zwar räumlich begrenzt auf den Bereich des Ringspalts, wohingegen im Bereich des Zentrums der Düse kein Materialabtrag stattfindet.

In einer alternativen Variante des FJP-Verfahrens wird eine horizontale Geschwindigkeitskomponente des Poliermittels durch eine zur Polieroberfläche schräg angeordnete Düse erreicht. Dies bietet den Vorteil, dass eine Erhöhung der Oberflächenrauheit durch den geringen Materialabtrag im Bereich des Zentrums der Düse in der zuvor beschriebenen Variante vermieden wird. Nachteilig dagegen ist der Verlust der Rotationssymmetrie des Abtragsprofils. Die kann jedoch zumindest teilweise durch eine Anordnung mehrerer schräg angeordneter Düsen behoben werden, die genau oder annähernd auf einen gemeinsamen Bearbeitungspunkt ausgerichtet sind. Durch die strömungstechnische Auslegung der Düsenanordnung lassen sich vielfältige Abtragsprofile entsprechend dem Bearbeitungsbedarf einstellen.

Alle hier genannten Varianten des FJP-Verfahrens stehen für das erfindungsgemäße Verfahren der Geometriekorrektur der Halbleiterscheibe als Alternativen zur Verfügung und bieten jeweils spezifische Parameterwerte bezüglich der Abtragsrate, des Abtragsprofils und der erreichbaren Oberflächenrauheit. Im Folgenden sollen diese Varianten zusammenfassend mit dem Begriff FJP-Verfahren bezeichnet werden.

Besteht die Halbleiterscheibe im Wesentlichen aus Silicium, wird als Poliermittel vorzugsweise eine Suspension von Siliciumoxid-Partikeln mit einem pH-Wert zwischen 7 und 11,5 verwendet. Der Anteil der Siliciumoxid-Partikel beträgt vorzugsweise 0,1 bis 2 % (Gewichtsprozent). Der Kupfergehalt des Poliermittels beträgt vorzugsweise maximal 0,04 ppm, der Nickelgehalt vorzugsweise maximal 0,1 ppm.

Da mit dem FJP-Verfahren nur eine geringe Materialabtragsrate erzielt werden kann, ist es bevorzugt, nicht eine gesamte Fläche (vorzugsweise die Vorderseite) der Halbleiterscheibe zu behandeln, sondern nur die Teilbereiche, in denen der Wert des zu optimierenden Geometrie-Parameters besonders schlecht ausfällt. Beispielsweise kann die FJP-Bearbeitung auf den an den Scheibenrand angrenzenden Bereich beschränkt werden, um die Ebenheit im Randbereich hinsichtlich des Parameters ESFQR zu verbessern. Auch eine FJP-Nachbearbeitung des Bereichs der Lasermarkierung ist bevorzugt, da dieser Bereich nach der Doppelseitenpolitur oft eine leichte Erhebung aufweist. Mit einer lokal auf den Bereich der Lasermarkierung beschränkten FJP-Bearbeitung kann diese Erhebung eingeebnet werden.

Nach der FJP-Behandlung kann zwecks Prozesskontrolle eine erneute Geometriemessung erfolgen.

Danach wird zumindest die Seite der Halbleiterscheibe, die zuvor der FJP-Behandlung unterzogen wurde, chemisch-mechanisch poliert. Dabei werden die Rauheitsunterschiede zwischen den doppelseitenpolierten und FJP-behandelten Bereichen entfernt und die Halbleiterscheibe erhält eine einheitlich glatte, schleierfrei polierte Oberfläche. Diese Politur wird vorzugsweise als eine Einseitenpolitur ausgeführt, wobei der Materialabtrag vorzugsweise nicht mehr als 1 µm, und besonders bevorzugt nicht mehr als 0,5 µm beträgt. Vorzugsweise wird dafür eine Poliermaschine mit Polierköpfen verwendet, die mehrere rotationssymmetrische Druckzonen aufweisen, wie beispielsweise in EP847835A1 beschrieben. Dies ermöglicht zusammen mit dem geringen Materialabtrag eine weitgehende Erhaltung der mittels FJP eingestellten Ebenheit im Randbereich der Halbleiterscheibe.

Im Folgenden werden besonders bevorzugte Ausführungsformen des erfindungsgemäßen Verfahrens beschrieben:
Eine erste besonders bevorzugte Ausführungsform ist speziell an die Verbesserung der Ebenheit im Randbereich der Halbleiterscheibe angepasst, um den Parameter ESFQR zu optimieren.

Bei dieser Ausführungsform wird die Doppelseitenpolitur vorzugsweise so durchgeführt, dass die Halbleiterscheibe eine möglichst gute globale Ebenheit (d.h. einen geringen GBIR) mit einer leichten Erhöhung in der Nähe des Randes aufweist. Bevorzugt liegt der GBIR ≤ 200 nm und besonders bevorzugt ≤ 150 nm. Gleichzeitig sollte schon durch die Doppelseitenpolitur ein vergleichsweise kleiner Randabfall erzielt werden, bevorzugt ESFQR_{avg} ≤ 40 nm und besonders bevorzugt ≤ 30 nm.

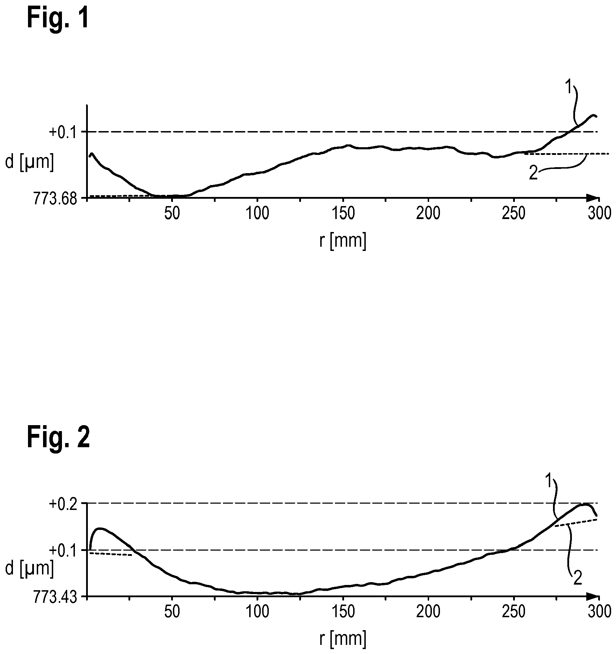

Dies lässt sich beispielsweise durch eine geeignete Wahl der Dicke der bei der Doppelseitenpolitur zur Führung der Halbleiterscheiben verwendeten Läuferscheiben in Relation zur Enddicke der polierten Halbleiterscheiben erreichen: Ist die Enddicke der polierten Halbleiterscheiben geringer als die Dicke der Läuferscheiben, so weisen die polierten Halbleiterscheiben ein leicht konkaves radiales Profil auf. Ein Randabfall am äußersten Rand, d.h. im Bereich von etwa 3 mm vom Scheibenrand einwärts, der die mit der Doppelseitenpolitur erreichbaren ESFQR-Werte limitiert, lässt sich auch in diesem Fall nicht vermeiden. Die Doppelseitenpolitur wird jedoch so durchgeführt, dass dieser Randabfall im nachfolgenden FJP-Schritt mit geringstmöglichem Materialabtrag entfernt werden kann. Der Materialabtrag bei der Doppelseitenpolitur beträgt vorzugsweise 8 - 10 µm. Kurve 1 in Fig. 1 zeigt ein derartiges radiales Profil, wie es bei dieser Ausführungsform durch die Doppelseitenpolitur erzeugt wird.

Im nachfolgenden FJP-Schritt muss lediglich eine Geometrie-Korrektur im Randbereich erfolgen. Da der zu bearbeitende Bereich rotationssymmetrisch ist, ist es bevorzugt, bei der FJP-Bearbeitung die Düse in einer oder mehreren Kreisbahnen oder spiralförmig über den zu bearbeitenden Bereich zu bewegen. Bei dieser Ausführungsform kann auf eine FJP-Bearbeitung der gesamten Vorderseite der Halbleiterscheibe verzichtet werden. Die Erhöhung im Randbereich wird mittels FJP mit geringstmöglichem Materialabtrag vorzugsweise so weit abgetragen, dass der Randabfall vollständig entfernt wird und das radiale Profil bis zum äußersten Rand entweder flach ist oder gleichmäßig ansteigt. Kurve 2 in Fig. 1 zeigt ein derart mittels FJP korrigiertes Profil. Im dargestellten Fall kann mit einem sehr geringen Materialabtrag im FJP-Schritt von insgesamt lediglich etwa 20 mm³ die Ebenheit des Randbereichs so verbessert werden, dass ein hervorragender ESFQR_{avg}-Wert von 8 nm oder weniger oder sogar von 5 nm oder weniger erzielt werden kann. Der ESFQR_{avg}-Wert kann bis auf etwa 1 bis 2 nm reduziert werden. Der geringe Materialabtrag sorgt für eine zeit- und damit kostensparende Anwendung des FJP-Verfahrens.

In einer **zweiten Ausführungsform** wird die FJP-Bearbeitung benutzt, um ein nach Doppelseitenpolitur nicht optimales Profil zu verbessern. Beispielsweise kann durch eine nicht optimale Prozessführung oder aufgrund unbeabsichtigter Abweichungen bei der Doppelseitenpolitur ein leicht konkaves radiales Profil entstehen, das einen im Vergleich zur ersten besonders bevorzugten Ausführungsform breiteren Randabfall aufweist. Dieser wird mit der nachfolgenden FJP-Bearbeitung ebenfalls vollständig entfernt. Bei dieser Ausführungsform wird FJP zur Nachbearbeitung von Halbleiterscheiben eingesetzt, die ansonsten aufgrund von Abweichungen bei der Doppelseitenpolitur verworfen werden müssten. Im Übrigen unterscheidet sich diese Ausführungsform nicht von der ersten besonders bevorzugten Ausführungsform. Fig. 2 stellt das radiale Profil vor der FJP-Bearbeitung (Kurve 1) und nach der FJP-Bearbeitung (Kurve 2) dar. In diesem Fall kann eine deutliche Verbesserung der Ebenheit im Randbereich der Halbleiterscheibe bereits im einem Materialabtrag von nur 10 mm³ die Ebenheit des Randbereichs deutlich verbessert werden, auch wenn in diesem Fall kein hervorragender ESFQR_{avg}-Wert von 8 nm oder weniger erzielt wird.

In einer **dritten besonders bevorzugten Ausführungsform** wird das FJP-Verfahren zur Entfernung einer nach der Doppelseitenpolitur feststellbaren Erhebung an der Stelle der Lasermarkierung benutzt. Erhebungen um die Lasermarkierung können entstehen, weil Silicium und Siliciumoxid bei der Doppelseitenpolitur unterschiedliche Abtragsraten aufweisen. Bei der Lasermarkierung können lokal Oxide entstehen, die bei der Doppelseitenpolitur den Materialabtrag verlangsamen und deshalb als Erhebung übrig bleiben. Auch in diesem Fall wird nicht die gesamte Vorderseite der Halbleiterscheibe bearbeitet, sondern nur der Bereich der Lasermarkierung.

In einer **vierten besonders bevorzugten Ausführungsform** wird das FJP-Verfahren zur Entfernung von lokalen Störungen der Oberfläche eingesetzt. Diese Störungen können z. B. lokale Erhebungen sein, die im Laufe der Abscheidung eines Niedertemperatur-Oxids (engl. "low temperature oxide", LTO) auf der Rückseite der Halbleiterscheibe entstehen. Sie werden als sog. "Spikes" bezeichnet und entstehen üblicherweise im Randbereich der Halbleiterscheibe. Um derartige lokale, nicht reproduzierbar an derselben Stelle entstehende Erhebungen entfernen zu können, muss jede Halbleiterscheibe einer Geometriemessung unterzogen werden, bevor der FJP-Schritt durchgeführt wird.

## Patentansprüche

1. Monokristalline Halbleiterscheibe mit einer mittleren Rauheit Rₐ von höchstens 0,8 nm bei einer Grenzwellenlänge von 250 µm, **gekennzeichnet durch** einen ESFQR_{avg} von 8 nm oder weniger bei einem Randausschluss von 1 mm, wobei die Messfelder zur Messung des ESFQR_{avg} eine radiale Länge von 30 mm aufweisen und die Breite der Messfelder sich durch eine gleichmäßige Aufteilung in 72 gleich große Sektoren ergibt.

2. Monokristalline Halbleiterscheibe gemäß Anspruch 1, **gekennzeichnet durch** einen ESFQR_{avg} von 5 nm oder weniger.

3. Monokristalline Halbleiterscheibe gemäß einem der Ansprüche 1 oder 2, **gekennzeichnet durch** einen mittels der Poly-UTP-Methode bestimmten Metallgehalt von höchstens 3×10¹⁰ cm⁻² für die Elemente Kupfer und Nickel.

4. Monokristalline Halbleiterscheibe gemäß einem der Ansprüche 1 bis 3, **dadurch gekennzeichnet, dass** die Halbleiterscheibe im Wesentlichen aus Silicium besteht.

5. Monokristalline Halbleiterscheibe gemäß Anspruch 4, **gekennzeichnet durch** einen Durchmesser von wenigstens 300 mm.

6. Verfahren zur Herstellung einer monokristallinen Halbleiterscheibe, umfassend folgende Schritte in der angegebenen Reihenfolge:
- Gleichzeitig beidseitige Politur der Halbleiterscheibe,
- lokale Material abtragende Bearbeitung mindestens eines Teils mindestens einer Fläche der Halbleiterscheibe mit einem Flüssigkeitsstrahl, der suspendierte Hartstoffpartikel enthält, und der mit Hilfe einer Düse auf einen kleinen Bereich der Fläche gerichtet wird, wobei die Düse derart über den zu behandelnden Teil der Fläche bewegt wird, dass ein vordefinierter Geometrie-Parameter der Halbleiterscheibe verbessert wird und
- Politur der wenigstens einen Fläche der Halbleiterscheibe.

7. Verfahren gemäß Anspruch 6, **dadurch gekennzeichnet, dass** die lokale Material abtragende Bearbeitung auf Basis einer nach der gleichzeitig beidseitigen Politur derselben Halbleiterscheibe durchgeführten ortsabhängigen Messung des Geometrie-Parameters erfolgt.

8. Verfahren gemäß Anspruch 7, **dadurch gekennzeichnet, dass** die lokale Material abtragende Bearbeitung auf Basis einer bekannten, nach einer gleichartigen gleichzeitig beidseitigen Politur gleichartiger Halbleiterscheiben durchgeführten ortsabhängigen Messung des Geometrie-Parameters erfolgt, ohne dass die zu behandelnde Halbleiterscheibe selbst dieser Messung unterzogen wird.

9. Verfahren gemäß einem der Ansprüche 6 bis 8, **dadurch gekennzeichnet, dass** der Geometrie-Parameter der Parameter ESFQR ist.

10. Verfahren gemäß einem der Ansprüche 6 bis 9, **dadurch gekennzeichnet, dass** die Material abtragende Bearbeitung mittels einer Düse durchgeführt wird, die in einem Abstand von 0,5 bis 3 mm über die zu bearbeitende Fläche geführt wird und durch die der Flüssigkeitsstrahl mit den suspendierten Hartstoffpartikeln austritt, wobei sich die Flüssigkeit zwischen der Düse und der Fläche staut und wobei der Materialabtrag überwiegend durch parallel zur Fläche zwischen der Fläche und dem Rand der Düse ausströmende Flüssigkeit mit suspendierten Hartstoffpartikeln erzielt wird.

11. Verfahren gemäß einem der Ansprüche 6 bis 10, **dadurch gekennzeichnet, dass** bei der abschließenden Politur der wenigstens einen Seite der Halbleiterscheibe nicht mehr als 1 µm Material abgetragen wird.

12. Verfahren gemäß einem der Ansprüche 6 bis 11, **dadurch gekennzeichnet, dass** bei der gleichzeitig beidseitigen Politur der Halbleiterscheibe ein Profil mit einer definierten Erhöhung in einem Bereich in der Nähe des Randes erzeugt wird.

13. Verfahren gemäß Anspruch 12, **dadurch gekennzeichnet, dass** bei der lokalen Material abtragenden Bearbeitung die Düse in Kreisbahnen oder spiralförmig über den Bereich in der Nähe des Randes geführt wird, in dem sich die Erhöhung befindet, sodass die Erhöhung im Laufe der lokalen Material abtragenden Bearbeitung zumindest teilweise abgetragen wird.

## Claims

1. Monocrystalline semiconductor wafer having an average roughness Rₐ of at most 0.8 nm at a limiting wavelength of 250 µm, **characterized by** an ESFQR_{avg} of 8 nm or less given an edge exclusion of 1 mm, the measurement fields for measuring the ESFQR_{avg} having a radial length of 30 mm and the width of the measurement fields resulting from a uniform division into 72 sectors of equal size.

2. Monocrystalline semiconductor wafer according to Claim 1, **characterized by** an ESFQR_{avg} of 5 nm or less.

3. Monocrystalline semiconductor wafer according to either of Claims 1 and 2, **characterized by** a metal content determined by means of the poly-UTP method of at most 3×10¹⁰ cm⁻² for the elements copper and nickel.

4. Monocrystalline semiconductor wafer according to any of Claims 1 to 3, **characterized in that** the semiconductor wafer substantially consists of silicon.

5. Monocrystalline semiconductor wafer according to Claim 4, **characterized by** a diameter of at least 300 mm.

6. Method for producing a monocrystalline semiconductor wafer, comprising the following steps in the indicated order:
- simultaneous double-side polishing of the semiconductor wafer,
- local material-removing processing of at least one part of at least one surface of the semiconductor wafer using a fluid jet which contains suspended hard substance particles and which is directed onto a small region of the surface with the aid of a nozzle, wherein the nozzle is moved over that part of the surface which is to be treated in such a way that a predefined geometry parameter of the semiconductor wafer is improved, and
- polishing of the at least one surface of the semiconductor wafer.

7. Method according to Claim 6, **characterized in that** the local material-removing processing is carried out on the basis of a location-dependent measurement of the geometry parameter that is carried out after the simultaneous double-side polishing of the same semiconductor wafer.

8. Method according to Claim 7, **characterized in that** the local material-removing processing is carried out on the basis of a known location-dependent measurement of the geometry parameter that is carried out after an identical type of simultaneous double-side polishing of semiconductor wafers of identical type, without the semiconductor wafer that is to be treated itself being subjected to this measurement.

9. Method according to any of Claims 6 to 8, **characterized in that** the geometry parameter is the parameter ESFQR.

10. Method according to any of Claims 6 to 9, **characterized in that** the material-removing processing is carried out by means of a nozzle which is guided over the surface to be processed at a distance of 0.5 to 3 mm and through which the fluid jet comprising the suspended hard substance particles emerges, wherein the fluid accumulates between the nozzle and the surface and wherein the material removal is predominantly achieved by fluid comprising suspended hard substance particles that flows out parallel to the surface between the surface and the edge of the nozzle.

11. Method according to any of Claims 6 to 10, **characterized in that** not more than 1 µm of material is removed in the final polishing of the at least one side of the semiconductor wafer.

12. Method according to any of Claims 6 to 11, **characterized in that** during the simultaneous double-side polishing of the semiconductor wafer a profile having a defined elevation is produced in a region in the vicinity of the edge.

13. Method according to Claim 12, **characterized in that** during the local material-removing processing the nozzle is guided in circular paths or spirally over the region in the vicinity of the edge in which the elevation is situated, such that the elevation is at least partly removed in the course of the local material-removing processing.

## Revendications

1. Plaquette de semi-conducteur monocristallin présentant une rugosité moyenne Rₐ de 0,8 nm maximum pour une longueur d'onde de coupure de 250 µm, **caractérisée par** un ESFQR_{avg} de 8 nm ou moins avec une exclusion de bord de 1 mm, les champs de mesure destinés à mesurer l'ESFQR_{avg} ayant une longueur radiale de 30 mm et la largeur des champs de mesure résultant d'une division égale en 72 secteurs de même dimension.

2. Plaquette de semi-conducteur monocristallin selon la revendication 1, **caractérisée par** un ESFQR_{avg} de 5 nm ou moins.

3. Plaquette de semi-conducteur monocristallin selon l'une des revendications 1 ou 2, **caractérisée par** une teneur en métal de 3×10¹⁰ cm⁻² pour les éléments cuivre et nickel, déterminée selon la méthode poly-UTP.

4. Plaquette de semi-conducteur monocristallin selon l'une des revendications 1 à 3, **caractérisée en ce que** la plaquette de semi-conducteur est sensiblement en silicium.

5. Plaquette de semi-conducteur monocristallin selon la revendication 4, **caractérisée par** un diamètre d'au moins 300 mm.

6. Procédé de réalisation d'une plaquette de semi-conducteur monocristallin, ledit procédé comprenant les étapes suivantes dans l'ordre indiqué :
- polir simultanément les deux faces de la plaquette de semi-conducteur,
- traiter localement par enlèvement de matière au moins une partie d'au moins une surface de la plaquette de semi-conducteur avec un jet de liquide qui contient des particules de matière dure en suspension et qui est dirigé sur une petite zone de la surface à l'aide d'une buse, la buse étant déplacée sur la partie à traiter de la surface de manière à améliorer un paramètre géométrique prédéfini de la plaquette de semi-conducteur et
- polir au moins une surface de la plaquette de semi-conducteur.

7. Procédé selon la revendication 6, **caractérisé en ce que** le traitement local par enlèvement de matière est effectué sur la base d'une mesure du paramètre géométrique, laquelle dépend de l'emplacement et est effectuée après le polissage simultané des deux faces de la même plaquette de semi-conducteur.

8. Procédé selon la revendication 7, **caractérisé en ce que** le traitement local par enlèvement de matière est effectué sur la base d'une mesure connue du paramètre géométrique, laquelle dépend de l'emplacement et est effectuée après un même polissage simultané des deux faces de plaquettes de semi-conducteur de même type, sans que la plaquette de semi-conducteur à traiter soit elle-même soumise à cette mesure.

9. Procédé selon l'une des revendications 6 à 8, **caractérisé en ce que** le paramètre géométrique est le paramètre ESFQR.

10. Procédé selon l'une des revendications 6 à 9, **caractérisé en ce que** le traitement par enlèvement de matière est effectué au moyen d'une buse qui est guidée sur la surface à traiter à une distance de 0,5 à 3 mm et de laquelle sort le jet de liquide pourvu des particules de matière dure en suspension, le liquide s'accumulant entre la buse et la surface et l'enlèvement de matière étant principalement effectué par un liquide pourvu de particules de matière dure en suspension qui s'écoule parallèlement à la surface entre la surface et le bord de la buse.

11. Procédé selon l'une des revendications 6 à 10, **caractérisé en ce que** pas plus de 1 um de matière est enlevé lors du polissage final de l'au moins une face de la plaquette de semi-conducteur.

12. Procédé selon l'une des revendications 6 à 11, **caractérisé en ce qu'**un profil d'une élévation définie est généré dans une zone proche du bord lors du polissage simultané de la plaquette de semi-conducteur sur les deux faces.

13. Procédé selon la revendication 12, **caractérisé en ce que**, lors du traitement local par enlèvement de matière, la buse est guidée suivant des trajets circulaires ou en spirale sur la zone proche du bord dans laquelle se trouve l'élévation, de façon à enlever l'élévation au moins partiellement au cours du traitement local par enlèvement de matière.
